# EUROPEAN PATENT SPECIFICATION

(11) **EP 1 457 550 B1**
(45) Date of publication and mention of the grant of the patent: **05.07.2006**
(21) Application number: 04011792.1
(22) Date of filing: 08.02.2002
(51) Int. Cl.: C11D 3/37, C11D 1/00, B08B 3/00, C11D 11/00, C11D 7/32, G03F 7/42, H01L 21/00

(54) **Composition for removing residues from the microstructure of an object**
Zusammensetzung für Rückstandentfernung von der Mikrostruktur eines Objekts
Composition pour l'enlèvement des résidus de la microstructure d'un objet

(30) Priority: 09.02.2001 JP 2001034337
(43) Date of publication of application: 15.09.2004
(62) Divisional of application: 02736487.6
(73) Proprietor: AIR PRODUCTS AND CHEMICALS, INC., Allentown, PA 18195-1501 (US)
(72) Inventor: Peters, Darryl W., Stewartsville, New Jersey 08886 (US); Egbe, Matthew I., West Norriton, Pennsylvania 19403 (US)
(74) Representative: Müller-Boré & Partner Patentanwälte

(56) References cited:
- EP-A- 1 365 441
- WO-A-01/33613
- WO-A-02/15251
- US-B1- 6 242 165
- US-B1- 6 306 564

## Description

The present invention relates to a composition for removing residues from the microstructure of an object. The present invention specifically relates to a composition for removing residues, such as resists, generated during a semiconductor manufacturing process from a semiconductor wafer surface having a fine structure of convex and concave portions.

It is required as one step in manufacturing a semiconductor wafer to remove residues, such as photoresists, UV-hardened resists, X-ray hardened resists, ashed resists, carbon-fluorine containing polymer, plasma etch residues, and organic or inorganic contaminants from the other steps of the manufacturing process. The dry and wet removal methods are commonly used. In the wet removal method, the semiconductor wafer is dipped in an agent, such as a water solution, including a remover to remove residues from the surface of semiconductor wafer. Recently, supercritical CO₂ is used as such an agent because of its low viscosity.

However, supercritical CO₂ is not enough by itself to remove several residues from the surface of the semiconductor wafer. To resolve this problem, several additives to supercritical CO₂ are proposed. As described in the Japanese unexamined patent publication No. 10-125644, methane or a surfactant having a CFx group is used as an additive to supercritical CO₂. In Japanese unexamined patent publication No. 8-191063, dimethylsulfoxide ordimethyl-formamide is used as such an additive. These additives are not always effective for removing residues.

Compositions for removing residues from the microstructure of an object are also known from WO 0133613-A, US 6242165 B, US 6306564 B, WO 0215251-A and US 5709756A.

An object of the present invention is, therefore, to provide a composition for effectively removing residues from the microstructure of an object.

According to the present invention, a composition is provided for removing residues from the object, comprising carbon dioxide; an additive for removing the residues comprising a fluoride having the formula NR₁R₂R₃R₄F, where R₁, R₂, R₃ and R₄ are a hydrogen or an alkyl group; and a co-solvent for dissolving said additive in said carbon dioxide at a pressurized fluid condition.

The foregoing and additional features and characteristics of the present invention will become more apparent from the following detailed description considered with reference to the accompanying drawings in which like reference numerals designate like elements and wherein:
FIG. 1 is a schematic diagram of an apparatus for removing residues useful for the composition of the present invention.
FIG. 2 is a schematic diagram of another embodiment of the apparatus for removing resides useful for the composition of the present invention.
FIG. 3 shows an effect of the concentration of tetramethylammoniumfluoride (hereinafter referred to as "TMAF") on the etch rate.
FIG. 4 shows an effect of the concentration of ethanol on the etch rate.
FIG. 5 is a schematic diagram of a third embodiment of the apparatus for removing residues useful for the composition of the present invention.

The present invention is applied to the microstructure of an object, e.g., a semiconductor wafer having a fine structure of convex and concave portions on its surface, and a substrate made of a metal, plastic or ceramic which forms or remains continuous or noncontinuous layer of materials different therefrom.

As the pressurized CO₂ is not enough by itself to remove residues, the pressurized CO₂ of the present invention, to which an additive and a co-solvent are added, is used as a remover for removing residues from the object. The additive used for this purpose can remove residues but cannot substantially dissolve in CO₂ by itself. The co-solvent used for this purpose can make the additive dissolved or dispersed homogeneously in CO₂.

The pressurized CO₂ has a high dispersion rate and enables the dissolved residues to disperse therein. If CO₂ is converted to a supercritical condition, it penetrates into fine pattern portions of the object more effectively. By this feature, the additive is conveyed into pores or concave portions on a surface of the object due to the low viscosity of CO₂.

The CO₂ is pressurized to 5 MPa or more, but not less than 7.1 MPa at a temperature of 31°C to convert the CO₂ to a supercritical fluid condition.

According to the present invention, the composition for removing residues from the microstructure of an object comprises an additive for removing the residues which comprises a fluoride having the formula NR₁R₂R₃R₄F, where R₁, R₂, R₃ and R₄ are a hydrogen or an alkyl group. It is preferable to use the fluoride with Rs being alkyl groups. Preferably, the fluoride having the formula NR₁R₂R₃R₄F is selected from the group consisting of tetramethylammonium fluoride (hereinafter referred to as TMAF), tetraethylammonium fluoride, tetrapropylammonium fluoride, tetrabutylammonium fluoride and choline fluoride.

The additive may further comprise a basic compound because it effectively hydrolyzes polymers typically used as a resist in manufacturing a semiconductor. The basic compound is preferably at least one element selected from the group consisting of quaternary ammoniumhydroxide, alkylamine, alkanolamine, and hydroxylamine. It is preferred to use a compound including at least one of quaternary ammoniumhydroxide, and hydroxylamine to remove novolac phenol resists from a semiconductor wafer. The quaternary ammoniumhydroxide may be any quaternary ammoniumhydroxide, e.g. tetramethylammoniumhydroxide, tetraethylammoniumhydroxide, tetrapropylammoniumhydroxide,tetrabutylammoniumhydroxide (hereinafter referred as TBAH), and choline. The alkylamine may be any alkylamine, e.g. methylamine, dimethylamine, ethylamine, diethylamine, triethylamine, and propylamine, dipropylamine. The alkanolamine may be any alkanolamine, e.g., monoethanolamine, diethanolamine, and triethanolamine.

The additive is preferably added in a ratio of not less than 0.001 wt. % of the remover, more preferably in a ratio of not less than 0.002 wt. %. When the additive is added in a ratio of more than 8 wt. %, the co-solvent should be added more, but the amount of CO₂ is decreased according to the amount of the added co-solvent, which decreases the penetration of CO₂ into a surface of the object. The upper range of the additive is 8 wt. %, preferably 6 wt. %, and more preferably 4 wt. %.

According to the present invention, the co-solvent is added to CO₂ together with the additive. The co-solvent of the present invention is a compound having an affinity to both CO₂ and the additive. Such a co-solvent dissolves or disperses the additive homogeneously in the pressurized CO₂ in fluid condition. An alcohol, dimethylsulfoxide or a mixture thereof is used as the co-solvent. The alcohol may be any alcohol, e.g. ethanol, methanol, n-propanol, iso-propanol, n-butanol, iso-butanol, diethyleneglycolmonomethyleter, diethyleneglycolmonoethyleter, and hexafluoro isopropanol, preferably ethanol and methanol.

The kind and amount of the co-solvent are selected depending on the kind and amount of the additive to CO₂. The amount of the co-solvent is preferably five times or more than that of the additive because the remover easily becomes homogeneous and transparent. Alternatively, the remover may include the co-solvent in a range of 1 wt. % to 50 wt. %. If more than 50 wt. % of the co-solvent is added, the penetration rate of the remover decreases due to less amount of CO₂. It is preferable to use a remover including CO₂, alcohol as the co-solvent, quaternary ammoniumfluoride and quaternary ammoniumhydroxide as the additive because these additives are well dissolved in CO₂ by alcohol and are CO₂-philic. According to the present invention, it is preferable to contact the object with a remover composed of CO₂, a fluoride of formula NR1R2R3R4F, (R represents a hydrogen or alkyl group), and a compound having hydroxyl group, while CO₂ is high pressurized or is preferably kept at a supercritical condition. This remover is more effective to remove ashed residues from the semiconductor wafer. The fluoride may be any fluoride of formula NR1R2R3R4F where R represents a hydrogen or alkyl group, e.g. ammonium fluoride, tetramethylammoniumfluoride, and tetraethylammoniumfluoride. It is preferable to use the fluoride with Rs being alkyl groups, such as tetramethylammoniumfluoride and tetraethylammoniumfluoride because such fluorides are CO₂-philic. In the present invention, the remover may include the fluoride preferably in the range from 0.001 wt % to 5 wt % of the remover, more preferably in the range from 0.002 wt % to 0.02 wt % of the remover.

The co-solvent is preferably a compound having a hydroxyl group, e.g., alcohol (such as ethanol, methanol, n-propanol, isopropanol, n-butanol and isobutanol , phenol), glycol (such as ethylenglycol and methylenglycol and polyethylenglycol). The alcohol is preferred because it effectively dissolves or disperses the fluoride, such as TMAF, homogeneously in supercritical CO₂. Among alcohol, ethanol is preferable because a larger amount of the fluoride, such as TMAF, can be dissolved in supercritical CO₂ by the presence of the ethanol. The concentration of the compound in supercritical CO₂ depends on the kind and concentration of the fluoride, and the kind of the residue. Approximately, the compound is preferably included in supercritical CO₂ in the range from 1 wt % to 20 wt % of the remover.

It is preferable that the supercritical CO₂ further comprises dimethylacetamide (hereinafter referred to as "DMAC"). The DMAC contained in the CO₂ is preferably six to seventy times of the fluoride contained in the CO₂ by weight. Further, it is preferable that the supercritical CO₂ includes substantially no water, which is a hindrance for manufacturing semiconductor wafers.

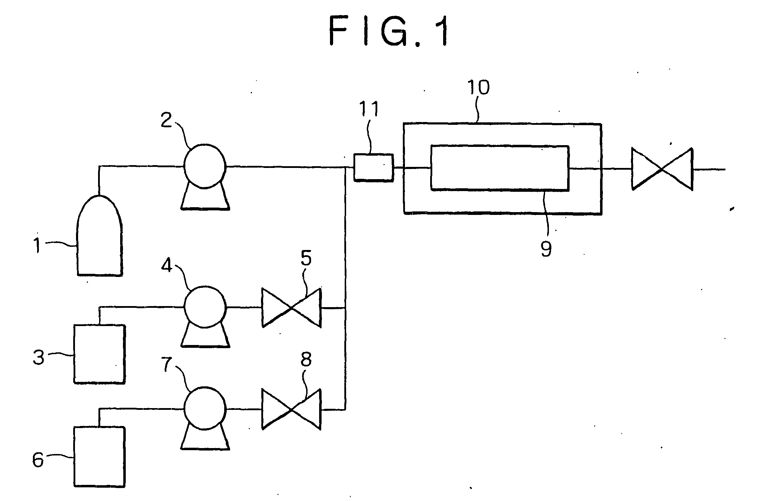

Figure 1 shows a simplified schematic drawing of an apparatus used for removing residues. Firstly, the semiconductor wafer having residues on its surface is introduced to and placed in a high pressure vessel 9, then CO₂ is supplied from a CO₂ cylinder 1 to the high pressure vessel 9 by a high pressure pump 2. The high pressure vessel 9 is thermostated at a specific temperature by a thermostat 10 in order to maintain the pressurized CO₂ in the high pressure vessel 9 at the supercritical condition. An additive and a co-solvent are supplied to the high pressure vessel 9 from tanks 3 and 6 by high pressure pumps 4 and 7, respectively, while the additive and co-solvent are mixed by a line mixer 11 on the way to the high pressure vessel 9. The flow rates of the additive and the co-solvent are adjusted by valves 5 and 8, respectively in order to set to the predetermined values. The CO₂, the additive and the co-solvent may be supplied continuously.

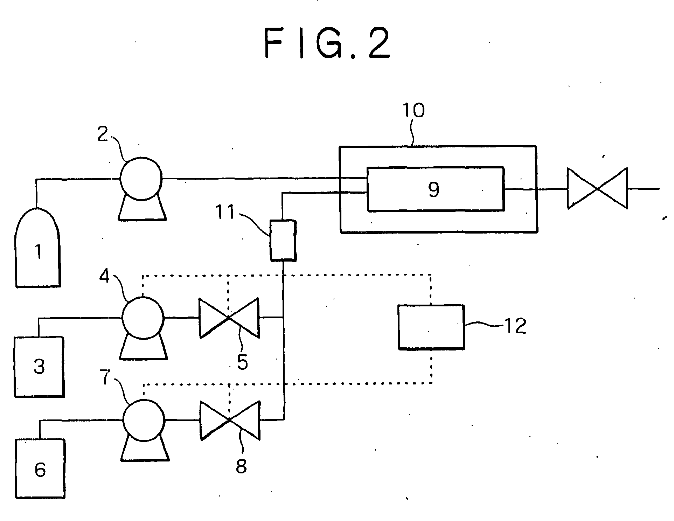

Figure 2 shows another embodiment of the apparatus for removing residues. In this apparatus, the additive is mixed with the co-solvent by the line mixer 11 before being fed into the high pressure vessel 9 in order to avoid heterogeneously contacting. The ratio of the additive and the co-solvent to be fed into the high pressure vessel 9 is controlled by a ratio controller 12, which regulates the feeding rate(s) of the additive and/or the co-solvent to the supercritical CO₂ in the high pressure vessel 9.

The removing process is performed at a temperature in the range from 31°C to 210°C, and at a pressure ranged from 5 M Pa to 30 M Pa, preferably, from 7.1 M Pa to 20 M Pa. The time required for removing the residues depends on the size of the object, the kind and amount of the residues, which is usually in the range from a minute to several ten minutes.

Hereinafter, the present invention is described with reference to experiments.

### EXPERIMENT 1

This experiment is carried out by dipping an object in an additive shown in table 1 at an atmospheric pressure at a temperature in the range of from 40°C to 100°C for 20 minutes. The object for this experiment is a silicon wafer having a SiO₂ layer coated with a novolac phenol type resist, patterned by a development, and treated to form microstructures on its surface by dry etching of a fluorine gas. A rate of removing residues is estimated as a ratio of an area of the surface adhering with residues after removing and before removing by a microscope. The term "×" and the term "O" mean that the rate is less than 90%, and 90% or more, respectively. The therm "Ø" means the rate is 90% or more when the additive is diluted ten times by a co-solvent such as dimethylsulfoxide.

The results are summarized in table 1.

**Table 1**

| Additive | Removability |
|---|---|
| Acetone | × |
| Dimethylformamide | × |
| Dimethylsulfoxide | × |
| N-methyl-2-pyroridon | × |
| Propylencarbonate | × |
| Methylamine | ○ |
| Ethylamine | ○ |
| Monoethanolamine | ○ |
| Hydroxytetramethylammonium solution* | ∅ |
| Choline solution** | ∅ |
| Hydroxylamine solution*** | ∅ |
| Ammonium fluoride solution**** | ∅ |

| | |
|---|---|
| *Hydroxytetramethylammonium solution (ethanol) includes 25% of hydroxytetramethylammonium. | |
| **Choline solution (water) includes 50% of choline. | |
| ***Hydroxylamine solution (water) includes 50% of hydroxylamine. | |
| **** Ammonium fluoride solution (water :dimethylformamide = 1:9) includes one percent of ammonium fluoride. | |

As shown in table 1, alkylamine (such as methylamine and ethylamine), alkanolamine (such as monoethanolamine), quaternary ammonium hydroxide (such as TMAH and choline), hydroxylamine, and ammonium fluoride have high removability. Especially, quaternary ammonium hydroxide,hydroxylamine, and ammonium fluoride have a superior rate for removing residues.

### EXPERIMENT 2

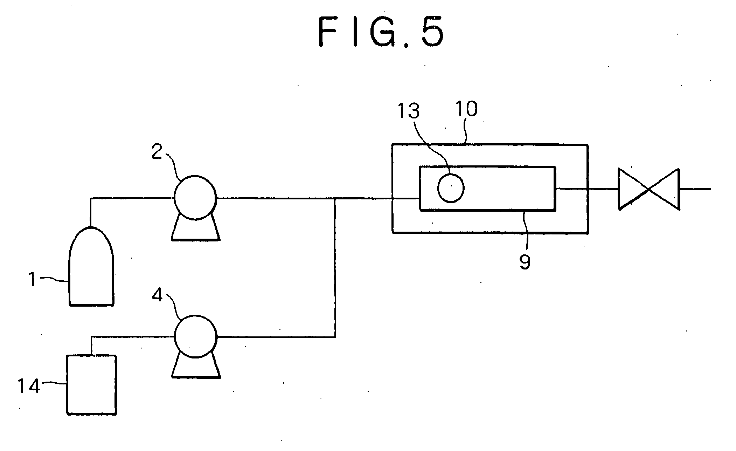

This experiment for investigating an effect of co-solvent on a solubility of additive in CO₂ is carried out via the apparatus shown in Fig. 5. CO₂ is introduced into the vessel 9 from the CO₂ cylinder 1 by the pump 2. The pressure and the temperature in the vessel are maintained at 20 MPa and 80°C by the thermostat 10. The additive and co-solvent are mixed in the ratio shown in table 2, then the mixture is introduced into the vessel 9 from the mixing tank 14 by the pump 4. The same amount of CO₂ as the mixture is evacuated from the vessel 9 so that the pressure is maintained at 20 MPa when the mixture is introduced. The effect of co-solvent, i.e., whether the additive is dissolved in CO₂, is observed through the glass window 13 of the vessel 9. When the additive is not dissolved in CO₂ two phases are observed through the window. The term "×" in table 2 means that the two phases are observed. The term "O" means the co-solvent makes the additive dissolved or dispersed homogeneously in CO₂ (the two phases are not observed).

**Table 2**

| Exp. No. | Additive | | Co-solvent | | Observation |
|---|---|---|---|---|---|
| | | wt % | | wt % | |
| 2-1 | TMAH | 1.21 | ethanol | 22.1 | ○ |
| 2-2 | TMAH | 1.50 | dimethylsulfoxide | 30.0 | ○ |
| 2-3 | TBAH | 0.40 | ethanol | 38.1 | ○ |
| 2-4 | choline | 0.05 | ethanol | 20.0 | ○ |
| 2-5 | choline | 1.76 | ethanol | 35.3 | ○ |
| 2-6 | choline | 0.25 | ethanol | 24.0 | ○ |
| 2-7 | choline | 0.29 | isopropanol | 27.9 | ○ |
| 2-8 | choline | 0.39 | DEGME | 38.3 | ○ |
| 2-9 | Mono-ethanolamine | 0.05 | ethanol | 25.0 | ○ |
| 2-10 | Non | | Non | | ○ |
| 2-11 | Non | | ethanol | 20.0 | ○ |
| 2-12 | choline | 0.05 | Non | | × |

| | | | | | |
|---|---|---|---|---|---|
| DEGME: diethyleneglycolmethylether | | | | | |

As shown in table 2, in experiment No. 2-1-2-9, the effects of co-solvents are confirmed. The conditions in experiment No. 2-1-2-9 observed through the window are transparent, homogenous, and without two phases.

### EXPERIMENT 3

This experiment for removing residues using a remover including high pressure CO₂, additive(s), and co-solvent(s) is carried out via the apparatus of Fig. 1. The object in this experiment is the same as the one in the experiment 1. The kind and concentration of the additive and co-solvent in the remover are shown in table 3. The term"∅", "○" and "×" in table 3 indicate the rate of removing residues being 90% or more, 60% or more, and 10% or less, respectively.

**Table 3**

| Exp. No. | Additive | | Co-solvent | | Rate |
|---|---|---|---|---|---|
| | | Wt% | | Wt% | |
| 3-1 | Choline | 0.05 | Ethanol | 20.0 | O |
| 3-2 | Choline | 1.70 | Ethanol | 35.3 | ∅ |
| 3-3 | TMAH | 1.21 | Methanol | 22.2 | ∅ |
| 3-4 | TMAH | 1.50 | Dimethylsulfoxide | 30.0 | ∅ |
| 3-5 | Non | | Non | | × |
| 3-6 | Non | | Ethanol | 20.0 | × |
| 3-7 | Non | | dimethylsulfoxide | 30.0 | × |

As shown in table 3, in the experiment No. 3-1-3-4, the residues are effectively removed.

### EXPERIMENT 4

This experiment for removing residues from the surface of semiconductor wafers is carried out by using a remover including additives H, I, G, J, L, and K which include the fluoride of formula NR1R2R3R4F (R represents a hydrogen or alkyl group). The compositions of the additives are listed in Table 4.

**Table 4 Compositions of Additive**

| Additive | Fluoride (wt % of additive) | Other components (wt % of additive) | |
|---|---|---|---|
| H | TMAF (13.43) | DMAC (62.5) | DIW (24.07) |
| I | TMAF (4.48) | DMAC (67.5) | DIW (28.02) |
| G | NH₄F (5.0) | DMAC (64.2) | DIW (12.4), AcOH (8.0), NH₄OAc (10.4) |
| J | TBAF (25) | DMAC (43) | Ethanol (32) |
| L | TBAF (32) | DMAC (39) | Ethanol (29) |
| K | TMAF (5) | DMAC (62.5) | Ethanol (32.5) |

| | | | |
|---|---|---|---|
| DMAC:Dimethylacetamide, DIW:De-ionized water, TMAF: Tetramethylammoniumfluoride, PG: Propyleneglycol, DMSO: Dimethylsulfoxide, AcOH: Acetic acid, TBAF: Tetrabutylammoniumfluoride, NH₄OAc: ammonium acetate. | | | |

In this experiment, three kinds of silicon wafers A, B and C are used. These silicon wafers have different patterns on their surfaces and the removing characteristics of their resists are also different. The silicon wafers are prepared to generate the thermal oxides of silicon on the surface thereof and broken into chips (1cm x 1cm). The chips are etched in the fluoride gas. Then the resists on the chips are ashed by a plasma to generate ashed resists. The chips are placed in the high pressure vessel 9. The solutions of additives H, I, G, J, K and L are prepared such that the fluoride is dissolved in the other components listed in the table 4, respectively. Then, such additives are introduced with CO₂ and ethanol into the high pressure vessel in Fig. 1. The temperature of CO₂ in the high pressure vessel 9 is 40°C, the pressure is 15 M Pa, and the time for making the chips contact with CO₂ is 3 minutes. After taken out from the high pressure vessel 9, the chips are observed with an electron microscope.

The result of this experiment is summarized in Table 5.

**Table 5**

| Run | Wafe r | Additive | Conc. in Remover [wt%] | | Result |
|---|---|---|---|---|---|
| | | | Additive | Ethanol | |
| 1 | A | H | 0.05 | 5 | Excellent |
| 2 | A | I | 0.05 | 5 | Excellent |
| 3 | B | H | 0.05 | 5 | Fair |
| 4 | B | H | 0.10 | 5 | Excellent |
| 5 | B | H | 0.25 | 5 | Fair |
| 6 | B | I | 0.05 | 5 | Fair |
| 7 | C | H | 0.10 | 5 | Excellent |
| 8 | A | G | 0.05 | 5 | Fair, but water rinse needs to remove the residue newly appeared |
| 9 | A | J | 0.05 | 5 | Excellent |
| 10 | A | K | 0.05 | 5 | Excellent |
| 11 | A | L | 0.05 | 5 | Excellent |
| 12 | B | J | 0.10 | 5 | Excellent |
| 13 | B | K | 0.10 | 5 | Excellent |
| 14 | B | L | 0.10 | 5 | Excellent |

The ashed resists on the wafer-A are cleaned by both 0.05wt% of H and I with 5wt% ethanol dissolved in the supercritical CO₂. The term "Excellent" means that there is no residues on the surface of the silicon wafer (chips). The term "Fair" means that there are a few residues on the surface or a little disappearance of the pattern. In Run 8 using NH₄F, a water rinse is needed to remove residue since a water-soluble residue newly appears on the surface of the silicon wafer (chips). In Runs 1 to 7 and 9 to 14, the water rinsing step subsequent to the removing step is not needed. In these cases, a solvent including CO₂ and alcohol, e.g. methanol and ethanol, but no water is preferably used for rinsing the silicon wafer. Further, in cases of the additives J, K and L, no water is substantially needed in both steps of removing and rinsing. Such method is superior because it uses substantially no water which becomes a hindrance for manufacturing semiconductor wafers.

Wafer-C contains more difficult ashed resists to be removed from the surface of the silicon wafer (chips). In order to remove this resist, longer removing time (three times longer than wafer-B) is required. The result is excellent.

### EXPERIMENT 5

The silicon wafers are prepared to generate the thermal oxides of silicon on their surface and are broken into chips. The chips are placed in the high pressure vessel 9 in Fig. 1. Then, a remover including CO₂, the additives, and ethanol is introduced into the high pressure vessel 9. After the removal treatment for several ten minutes, the chips are taken out and the thickness of the thermal oxides on the chips is measured by an ellipseometer. The etch rate of the thermal oxides is determined by dividing the decrease of the thickness per the treatment time. The temperature of CO₂ at the supercritical condition is 40C, the pressure is 15 M Pa, and the treatment time is 20 to 60 minutes.

The result of this experiment is summarized in Table 6

**Table 6**

| Additive | Concentration in Remover [wt%] | | Etch Rate of thermal oxides of silicon [A/min] |
|---|---|---|---|
| | additive | Ethanol | |
| H | 0.030 | 5.9 | 2.4 |
| H | 0.047 | 4.7 | 4.6 |
| H | 0.228 | 4.3 | 7.5 |
| I | 0.025 | 5.1 | 1.4 |
| I | 0.044 | 2.2 | 3.3 |
| I | 0.048 | 4.8 | 1.6 |
| I | 0.049 | 4.8 | 1.6 |
| I | 0.050 | 5.0 | 1.7 |
| I | 0.050 | 10.0 | 0.3 |
| I | 0.056 | 5.5 | 1.6 |
| I | 0.057 | 2.8 | 2.0 |
| I | 0.057 | 5.6 | 1.9 |
| I | 0.071 | 3.5 | 3.7 |
| I | 0.248 | 4.7 | 5.3 |
| G | 0.005 | 5.1 | 1.1 |
| G | 0.012 | 4.7 | -0.1 |
| G | 0.028 | 5.5 | 3.9 |
| G | 0.039 | 5.1 | 8.3 |
| G | 0.043 | 4.2 | 7.9 |
| G | 0.044 | 4.4 | 5.1 |

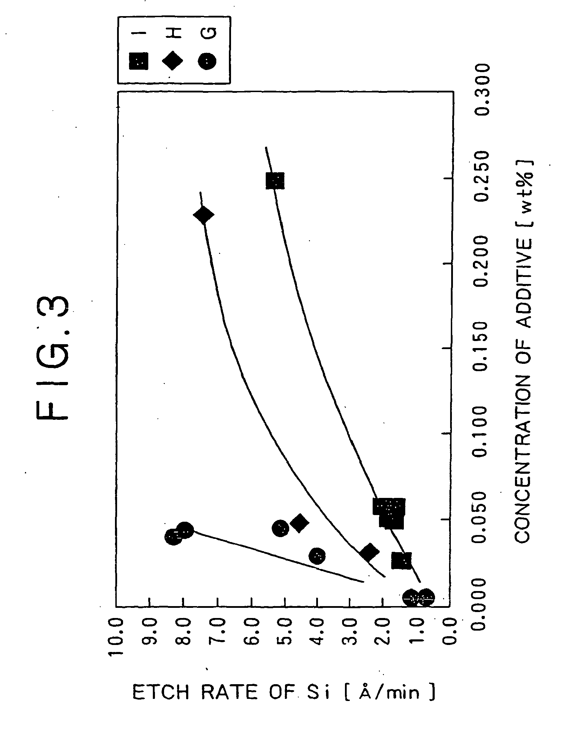

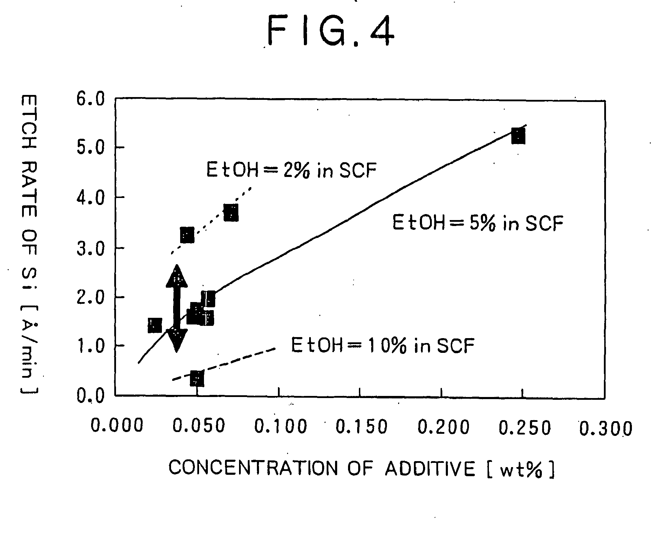

These data in table 6 are plotted in Figures 3 and 4. As shown in Figure 3, the etch rate of thermal oxides depends on the concentration of additives. Besides, as shown in Figure 4, if the concentration of the additive is constant, the etch rate varies according to the ethanol concentration. The etch rate can be controlled according to the removing objects or the removing process. As seen from Figures 3 and 4, the etch rate is controlled by adjusting the concentrations of the additive and ethanol, and their ratio.

## Claims

1. A composition for removing residues from the microstructure of an object, comprising:
carbon dioxide;
an additive for removing the residues comprising a fluoride having the formula NR₁R₂R₃R₄F, where R₁, R₂, R₃ and R₄ are a hydrogen or an alkyl group; and
a co-solvent for dissolving said additive in said carbon dioxide at a pressurized fluid condition.

2. The composition according to claim 1, wherein R₁, R₂, R₃ and R₄ are hydrogen.

3. The composition according to claim 1, wherein R₁, R₂, R₃ and R₄ are an alkyl.

4. The composition according to claim 1, wherein the fluoride having the formula NR₁R₂R₃R₄F is selected from the group consisting of tetramethylammonium fluoride, tetraethylammonium fluoride, tetrapropylammonium fluoride, tetrabutylammonium fluoride and choline fluoride.

5. The composition according to anyone of claims 1 to 4, wherein said co-solvent is an alcohol, dimethylsulfoxide or a mixture thereof.

6. The composition according to anyone of claims 1 to 4, wherein said co-solvent is a compound having a hydroxyl group.

7. The composition according to claim 6, wherein said compound having a hydroxyl group is an alcohol or a glycol.

8. The composition according to claim 7, wherein said compound having a hydroxyl group is selected from the group consisting of methanol, ethanol, n-propanol, iso-propanol, n-butanol, iso-butanol, diethyleneglycolmonomethylether, diethyleneglycolmonoethylether, hexafluoro isopropanol, phenol, methylene glycol, ethylene glycol, and polyethylene glycol.

9. The composition according to any one of claims 1 to 8, wherein said additive further comprises a basic compound, wherein said basic compound is at least one element selected from the group consisting of quaternary ammonium hydroxide, alkylamine, alkanolamine and hydroxylamine.

10. The composition according to any one of claims 1 to 9, wherein said composition is substantially free of water.

11. The composition according to any one of claims 1 to 10, wherein said carbon dioxide is converted to a supercritical condition.

12. The composition according to any one of claims 1 to 11, wherein said additive is present in said composition in the range of from 0.001 wt% to 8 wt%.

13. The composition according to any one of claims 1 to 12, wherein the co-solvent is present in the composition in the range of from 1 wt% to 50 wt%.

14. The composition according to any one of claims 1 to 13, wherein the residues are selected from photoresists, UV-hardened resists, X-ray hardened resists, ashed resists, carbon-fluorine containing polymer, plasma etch residues, and organic or inorganic contaminants.

## Patentansprüche

1. Zusammensetzung zum Entfernen von Rückständen von der Mikrostruktur eines Objektes, umfassend:
Kohlendioxid;
ein Additiv zum Entfernen der Rückstände, umfassend ein Fluorid mit der Formel NR₁R₂R₃R₄F, wobei R₁, R₂, R₃ und R₄ Wasserstoff oder ein Alkylrest sind; und
ein Hilfslösungsmittel zum Lösen des Additivs in dem Kohlendioxid bei einer Bedingung eines unter inneren Überdruck gesetzten Fluids.

2. Zusammensetzung gemäß Anspruch 1, wobei R₁, R₂, R₃ und R₄ Wasserstoff sind.

3. Zusammensetzung gemäß Anspruch 1, wobei R₁, R₂, R₃ und R₄ ein Alkyl sind.

4. Zusammensetzung gemäß Anspruch 1, wobei das Fluorid mit der Formel NRiR₂R₃R₄F aus der Gruppe, bestehend aus Tetramethylammoniumfluorid, Tetraethylammoniumfluorid, Tetrapropylammoniumfluorid, Tetrabutylammoniumfluorid und Cholinfluorid, ausgewählt ist.

5. Zusammensetzung gemäß einem der Ansprüche 1 bis 4, wobei das Hilfslösungsmittel ein Alkohol, Dimethylsulfoxid oder ein Gemisch davon ist.

6. Zusammensetzung gemäß einem der Ansprüche 1 bis 4, wobei das Hilfslösungsmittel eine Verbindung mit einer Hydroxylgruppe ist.

7. Zusammensetzung gemäß Anspruch 6, wobei die Verbindung mit einer Hydroxylgruppe ein Alkohol oder ein Glykol ist.

8. Zusammensetzung gemäß Anspruch 7, wobei die Verbindung mit einer Hydroxylgruppe aus der Gruppe, bestehend aus Methanol, Ethanol, n-Propanol, Isopropanol, n-Butanol, Isobutanol, Diethylenglykolmonomethylether, Diethylenglykolmonoethylether, Hexafluoroisopropanol, Methylenglykol, Ethylenglykol und Polyethylenglykol, ausgewählt ist.

9. Zusammensetzung gemäß einem der Ansprüche 1 bis 8, wobei das Additiv weiter eine basische Verbindung umfaßt, wobei die basische Verbindung mindestens ein Mitglied, ausgewählt aus der Gruppe, bestehend aus quaternärem Ammoniumhydroxid, Alkylamin, Alkanolamin und Hydroxylamin, ist.

10. Zusammensetzung gemäß einem der Ansprüche 1 bis 9, wobei die Zusammensetzung im wesentlichen frei von Wasser ist.

11. Zusammensetzung gemäß einem der Ansprüche 1 bis 10, wobei das Kohlendioxid zu einer super kritischen Bedingung umgewandelt wird.

12. Zusammensetzung gemäß einem der Ansprüche 1 bis 11, wobei das Additiv in der Zusammensetzung in dem Bereich von 0,001 Gew.-% bis 8 Gew.-% vorhanden ist.

13. Zusammensetzung gemäß einem der Ansprüche 1 bis 12, wobei das Hilfslösungsmittel in der Zusammensetzung in dem Bereich von 1 Gew.-% bis 50 Gew.-% vorhanden ist.

14. Zusammensetzung gemäß einem der Ansprüche 1 bis 13, wobei die Rückstände aus Photoresisten, UV-gehärteten Resisten, mit Röntgenstrahl gehärteten Resisten, veraschten Resisten, Kohlenstoff-Fluor-enthaltendem Polymer, Plasmaätzrückständen und organischen oder anorganischen Kontaminanten, ausgewählt sind.

## Revendications

1. Composition pour éliminer les résidus de la microstructure d'un objet, comprenant :
du dioxyde de carbone ;
un additif pour éliminer les résidus comprenant un fluorure de formule NR₁R₂R₃R₄F, où R₁, R₂, R₃ et R₄ sont un hydrogène ou un groupe alkyle ; et
un co-solvant pour dissoudre ledit additif dans ledit dioxyde de carbone dans une condition de fluide pressurisé.

2. Composition selon la revendication 1, dans laquelle R₁, R₂, R₃ et R₄ sont un hydrogène.

3. Composition selon la revendication 1, dans laquelle R₁, R₂, R₃ et R₄ sont un alkyle.

4. Composition selon la revendication 1, dans laquelle le fluorure de formule NR₁R₂R₃R₄F est choisi dans le groupe comprenant le fluorure de tétraméthylammonium, le fluorure de tétraéthylammonium, le fluorure de tétrapropylammonium, le fluorure de tétrabutylammonium et le fluorure de choline.

5. Composition selon l'une quelconque des revendications 1 à 4, dans laquelle ledit co-solvant est un alcool, le diméthylsulfoxyde ou un mélange de ceux-ci.

6. Composition selon l'une quelconque des revendications 1 à 4, dans laquelle ledit co-solvant est un composé possédant un groupe hydroxyle.

7. Composition selon la revendication 6, dans laquelle ledit composé possédant un groupe hydroxyle est un alcool ou un glycol.

8. Composition selon la revendication 7, dans laquelle ledit composé possédant un groupe hydroxyle est choisi dans le groupe comprenant le méthanol, l'éthanol, le n-propanol, l'iso-propanol, le n-butanol, l'iso-butanol, le diéthylène glycolmonométhyléther, le diéthylène glycol monoéthyléther, l'hexafluoro iso-propanol, le phénol, le méthylène glycol, l'éthylène glycol, et le polyéthylène glycol.

9. Composition selon l'une quelconque des revendications 1 à 8, dans laquelle ledit additif comprend en outre un composé de base, dans lequel ledit composé de base est au moins un élément choisi dans le groupe comprenant un hydroxyde d'ammonium quaternaire, une alkylamine, une alcanolamine et l'hydroxylamine.

10. Composition selon l'une quelconque des revendications 1 à 9, dans laquelle ladite composition ne comprend pratiquement pas d'eau.

11. Composition selon l'une quelconque des revendications 1 à 10, dans laquelle ledit dioxyde de carbone est converti en une condition surcritique.

12. Composition selon l'une quelconque des revendications 1 à 11, dans laquelle la quantité dudit additif présent dans ladite composition est dans la gamme de 0,001 % en poids à 8 % en poids.

13. Composition selon l'une quelconque des revendications 1 à 12, dans laquelle la quantité de co-solvant présent dans la composition est dans la gamme de 1% en poids à 50 % en poids.

14. Composition selon l'une quelconque des revendications 1 à 13, dans laquelle les résidus sont choisis parmi les réserves photosensibles, les réserves durcies sous UV, les réserves durcies sous rayon X, les réserves de cendre, un polymère contenant un fluorure de carbone, les résidus de gravure par plasma, et des contaminants organiques ou inorganiques.
